(19) Europäisches Patentamt
European Patent Office
Office européen des brevets

(11) **EP 3 364 201 B1**

(12) **EUROPEAN PATENT SPECIFICATION**

(45) Date of publication and mention
of the grant of the patent:
**30.03.2022  Bulletin 2022/13**

(21) Application number: **17156734.0**

(22) Date of filing: **17.02.2017**

(51) International Patent Classification (IPC):
**G01R 31/08** [(2020.01)]

(52) Cooperative Patent Classification (CPC):
**G01R 31/08**

(54) **METHOD OF IDENTIFYING A FAULT IN A RAILWAY ELECTRIFICATION SYSTEM**

VERFAHREN ZUR IDENTIFIKATION VON FEHLERN BEI EINEM BAHNELEKTRIFIZIERUNGSSYSTEM

PROCÉDÉ D'IDENTIFICATION D'UN DÉFAUT DANS UN SYSTÈME D'ÉLECTRIFICATION DE CHEMIN DE FER

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.08.2018  Bulletin 2018/34**

(73) Proprietor: **General Electric Technology GmbH 5400 Baden (CH)**

(72) Inventor: **HA, Hengxu Stafford, Staffordshire ST16 3SL (GB)**

(74) Representative: **Openshaw & Co.
8 Castle Street
Farnham, Surrey GU9 7HR (GB)**

(56) References cited:
**ES-A1- 2 507 465     US-A- 5 428 549**

- **JESUS SERRANO ET AL: "A Novel Ground Fault Identification Method for 2 x 5 kV Railway Power Supply Systems", ENERGIES, vol. 8, no. 7, 13 July 2015 (2015-07-13), pages 7020-7039, XP055397116, DOI: 10.3390/en8077020**

**Description**

This invention relates to a method of identifying a fault in a railway electrification system, and to an apparatus for identifying a fault in a railway electrification system.

It is known to supply electrical power to railway trains and trams by way of a railway electrification system. Determination of fault locations in such systems can be found in the following documents:

JESUS SERRANO ET AL: "A Novel Ground Fault Identification Method for 2 × 5 kV Railway Power Supply Systems",ENERGIES, vol. 8, no. 7, 13 July 2015 (2015-07-13), pages 7020-7039, XP055397116
Patent Application US5428549
Patent Application ES2507465

According to a first aspect of the invention, there is provided a method of identifying a fault in a railway electrification system, the railway electrification system comprising: an electrical power source; a supply conductor; a return conductor; a rail line; and a plurality of autotransformers, the supply conductor configured to supply electrical power from the electrical power source to a rail vehicle on the rail line, the return conductor configured to provide a current return path to the electrical power source, the rail line electrically connected to ground, each autotransformer arranged along the rail line and configured to electrically interconnect the supply conductor, return conductor and rail line, the method comprising the steps of:

determining voltage and current phasors from voltage and current measured at the electrical power source;
determining, based on the voltage and current phasors, whether the fault is located between the supply and return conductors or between the supply conductor and ground;
determining, based on the voltage and current phasors, the location of the fault along the supply conductor.

The role of autotransformers in a railway electrification system is to address the issue of voltage drops along the supply conductor. On the other hand, the inclusion of autotransformers in the railway electrification system renders it difficult to identify the type and location of a fault in the railway electrification system, which is detrimental to the safety and reliability of the railway electrification system. This is because, unlike conventional methods in which the fault distance is calculated based on a linear relationship between the fault distance and a measured impedance of the supply conductor, the presence of autotransformers in the railway electrification system means that the conventional methods for calculating the fault distance based on the linear relationship are no longer valid for a fault located between the supply conductor and ground. Also, the presence of autotransformers makes it difficult to use conventional methods to identify the type of fault.

The method of the invention advantageously overcomes the aforementioned problem associated with the inclusion of the autotransformers in that the method of the invention enables the reliable identification of the type and location of a fault in the railway electrification system by utilising voltage and current phasors determined from voltage and current measured at the electrical power source.

Moreover the method of the invention does not require remote measurements to help identify the type and location of a fault in the railway electrification system. This beneficially results in a cheaper and less complex railway electrification system since there is not only no need to install remote sensors along the length of the railway electrification system but also no need to install and manage additional hardware associated with remote sensors, such as communication links and remote location devices.

The electrical power source may be, but is not limited to, a feeder substation configured to feed power from a multi-phase AC electrical network.

The supply conductor may be, but is not limited to, an overhead line conductor, which is also known as an overhead wire or catenary.

The return conductor may be, but is not limited to, a feeder conductor.

The supply conductor may be configured to supply electrical power from the electrical power source to a rail vehicle on the rail line in a variety of ways. For example, the supply conductor may be configured to electrically couple with an electrical collector, such as a pantograph, of the rail vehicle in order to supply electrical power from the electrical power source to the rail vehicle. Furthermore the supply conductor may be electrically coupled to the electrical collector via a separate contact wire.

Each autotransformer is preferably arranged along the rail line and configured to electrically interconnect the supply conductor, return conductor and rail line such that the autotransformers are spaced apart at intervals (which may be regular or otherwise) to divide the railway electrification system into a plurality of sections.

It will be understood that, whilst the method of the invention is not restricted from being used in combination with another way of identifying a fault in a railway electrification system, the method of the invention is preferably carried out using only the voltage and current phasors determined from voltage and current measured at the electrical power source, which may be or may be part of a substation. Thus, in embodiments of the invention, the determination of whether the fault is located between the supply and return conductors or between the supply conductor and ground may be based on only the voltage and current phasors and/or the determination of the location of the fault along the supply conductor may be based on only the voltage and current phasors. This in turn results in a simpler method of identifying and locating a fault in a railway electrification system which avoids the extra costs associated with the use of additional measurements and corresponding communication devices, and additionally speeds up the determination of the fault type and location, which can be crucial in ensuring the safety and reliability of the railway electrification system.

The determination of the voltage and current phasors from voltage and current measured at the electrical power source may be carried out in a variety of ways, examples of which are described as follows.

The step of determining voltage and current phasors from voltage and current measured at the electrical power source may include filtering the measured voltage and current, for example filtering one or more decaying direct current components from the measured voltage and current.

The step of determining voltage and current phasors from voltage and current measured at the electrical power source may include:

(a) processing the measured voltage and current with a cosine filter based on the following equation:

$$XCOS(n) = \frac{2}{N_{spc}} \sum_{k=1}^{N_{spc}} X(n - N_{spc} + k) \cdot \cos(\frac{2\pi k}{N_{spc}} - \frac{\pi}{N_{spc}}),$$

where $X$ is the measured voltage or current, $XCOS(n)$ is the filtered voltage or current, n is the discrete time and $N_{spc}$ is the number of samples per cycle of fundamental frequency of the electrical power source;
(b) determining the real part of each phasor based on the following equation:

$$X\mathrm{Re}(n) = XCOS(n-1)$$

where $X\mathrm{Re}(n)$ is the real part of the voltage or current phasor;
(c) determining the imaginary part of each phasor based on the following

equation: $$X\,\mathrm{Im}(n) = \frac{[XCOS(n) - XCOS(n-2)]}{K}$$

where $$K = 2\sin\left(\frac{2\pi}{N_{spc}}\right)$$ , and $X\,\mathrm{Im}(n)$ is the imaginary part of the voltage or current phasor.

The determination of whether the fault is located between the supply and return conductors or between the supply conductor and ground based on the voltage and current phasors may be carried out in a variety of ways, examples of which are described as follows.

For example, the step of determining, based on the voltage and current phasors, whether the fault is located between the supply and return conductors or between the supply conductor and ground may include:

(a) determining an estimated distance of the fault from the electrical power source along the supply conductor based on the voltage and current phasors and the positive sequence impedance of the supply conductor in ohms per length;

(b) determining an additional impedance based on the voltage and current phasors, the positive sequence impedance of the supply conductor in ohms per length, the estimated distance of the fault from the electrical power source along the supply conductor, the zero sequence impedance in ohms per length, and the distance between successive autotransformers arranged along the rail line;

(c) determining a corrected distance of the fault from the electrical power source along the supply conductor based on the additional impedance, the voltage and current phasors and the positive sequence impedance of the supply conductor in ohms per length;

(d) determining whether the fault is located between the supply and return conductors or between the supply conductor and ground by comparing the ratio of first and second values against a criterion threshold, wherein the first value is based on the corrected distance and the real parts of the voltage and current phasors and the positive sequence impedance of the supply conductor in ohms per length, and the second value is based on the corrected distance and the imaginary parts of the voltage and current phasors and the positive sequence impedance of the supply conductor in ohms per length, wherein the fault is determined to be located between the supply conductor and ground when the ratio exceeds the criterion threshold, and wherein the fault is determined to be located between the supply and return conductors when the ratio does not exceed the criterion threshold.

The estimated distance of the fault from the electrical power source along the supply conductor may be determined based on the following equation:

$$x_0 = \frac{imag\left(\dfrac{\dot{U}_1}{\dot{I}_1}\right)}{imag\,(z_1)}$$

where $x_0$ is the estimated distance of the fault from the electrical power source along the supply conductor, $\dot{U}_1$ is the voltage phasor, $\dot{I}_1$ is the current phasor, $z_1$ is the positive sequence impedance of the supply conductor in ohms per length, and the function $imag\,(y)$ defines taking the imaginary part of the term $y$.

The additional impedance may be determined based on the following equations:

$$\Delta Z_{real} = real\left(\frac{\dot{U}_1}{\dot{I}_1}\right) - real\,(z_1)\cdot x_0$$

$$\Delta Z_{imag} = \frac{(x_0 - ND)(ND + D - x_0)}{D}\cdot imag\,(z_0)$$

$$\Delta Z = \Delta Z_{real} + j\cdot\Delta Z_{imag}$$

where $\Delta Z$ is the additional impedance, $\Delta Z_{real}$ is the real part of $\Delta Z$, $\Delta Z_{imag}$ is the imaginary part of $\Delta Z$, $\dot{U}_1$ is the voltage phasor, $\dot{I}_1$ is the current phasor, $z_1$ is the positive sequence impedance of the supply conductor in ohms per length, $x_0$ is the estimated distance of the fault from the electrical power source along the supply conductor, the function $real(y)$

$$N = floor\left(\frac{x_0}{D}\right)$$

defines taking the real part of the term $y$, , the function $floor(y)$ defines giving the largest integer number less than or equal to the term $y$, $z_0$ is the zero sequence impedance of the supply conductor in ohms per length, the function $imag\,(y)$ defines taking the imaginary part of the term $y$, and $D$ is the distance between successive autotransformers arranged along the rail line.

The corrected distance of the fault from the electrical power source along the supply conductor may be determined based on the following equation:

$$x_1 = \frac{imag\left(\dfrac{\dot{U}_1}{\dot{I}_1} - \Delta Z\right)}{imag\,(z_1)}$$

where $x_1$ is the corrected distance of the fault from the electrical power source along the supply conductor, $\dot{U}_1$ is the voltage phasor, $\dot{I}_1$ is the current phasor, $\Delta Z$ is the additional impedance, $z_1$ is the positive sequence impedance of the supply conductor in ohms per length, and the function *imag (y)* defines taking the imaginary part of the term *y*.

The determination of whether the fault is located between the supply and return conductors or between the supply conductor and ground may be based on the following criterion:

$$\frac{real\left(\dfrac{\dot{U}_1}{\dot{I}_1}\right) - real(z_1) \cdot x_1}{imag\left(\dfrac{\dot{U}_1}{\dot{I}_1}\right) - imag(z_1) \cdot x_1} > K_{set}$$

where $\dot{U}_1$ is the voltage phasor, $\dot{I}_1$ is the current phasor, $z_1$ is the positive sequence impedance of the supply conductor in ohms per length, $x_1$ is the corrected distance of the fault from the electrical power source along the supply conductor, the function *real(y)* defines taking the real part of the term *y,* the function *imag(y)* defines taking the imaginary part of the term *y,* and $K_{set}$ is the criterion threshold (which e.g. may be given by $K_{set} = ctg(arg(z_1)\text{-}5°)$). The fault is determined to be located between the supply conductor and ground when the ratio exceeds the criterion threshold, and wherein the fault is determined to be located between the supply and return conductors when the ratio does not exceed the criterion threshold.

The determination of the location of the fault along the supply conductor based on the voltage and current phasors may be carried out in a variety of ways, examples of which are described as follows.

For example, the step of determining, based on the voltage and current phasors, the location of the fault along the supply conductor may include determining the distance of the fault from the electrical power source along the supply conductor based on the imaginary parts of the voltage and current phasors and the impedance of the supply conductor in ohms per length.

The distance of the fault from the electrical power source along the supply conductor may be determined based on the following equation when the fault is between the supply conductor and ground:

$$imag(\dot{U}_1) = imag(z_1\dot{I}_1)x + \frac{(x - ND)(ND + D - x)}{D}]imag(z_0\dot{I}_1)$$

where *x* is the distance of the fault from the electrical power source along the supply conductor, $\dot{U}_1$ is the voltage phasor, $\dot{I}_1$ is the current phasor, $z_1$ is the positive sequence impedance of the supply conductor in ohms per length,

$N = floor\left(\dfrac{x}{D}\right)$, the function floor defines giving the largest integer number less than or equal to the term $\left(\dfrac{x}{D}\right)$, *D* is the distance between successive autotransformers along the rail line; $z_0$ is the zero sequence impedance of the supply conductor in ohms per length, and the function *imag (y)* defines taking the imaginary part of the term *y*.

The distance of the fault from the electrical power source along the supply conductor may be determined based on the following equation when the fault is located between the supply and return conductors:

$$x = \frac{imag\left(\dfrac{\dot{U}_1}{\dot{I}_1}\right)}{imag(z_1)}$$

where $x$ is the distance of the fault from the electrical power source along the supply conductor, $\dot{U}_1$ is the voltage phasor, $\dot{I}_1$ is the current phasor, $z_1$ is the positive impedance of the supply conductor in ohms per length, and the function *imag (y)* defines taking the imaginary part of the term *y*.

According to a second aspect of the invention, there is provided an apparatus for identifying a fault in a railway electrification system, the railway electrification system comprising: an electrical power source; a supply conductor; a return conductor; a rail line; and a plurality of autotransformers, the supply conductor configured to supply electrical power from the electrical power source to a rail vehicle on the rail line, the return conductor configured to provide a current return path to the electrical power source, the rail line electrically connected to ground, each autotransformer arranged along the rail line and configured to electrically interconnect the supply conductor, return conductor and rail line, the apparatus configured to:

determine voltage and current phasors from voltage and current measured at the electrical power source;

determine, based on the voltage and current phasors, whether the fault is located between the supply and return conductors or between the supply conductor and ground;

determine, based on the voltage and current phasors, the location of the fault along the supply conductor.

The features and advantages of the method of the first aspect of the invention and its embodiments apply mutatis mutandis to the apparatus of the second aspect of the invention. In particular, the apparatus may be configured to perform the steps of the method of the first aspect of the invention, or may be configured to perform any of the optional steps of the embodiments of the method of the first aspect of the invention.

According to a third aspect of the invention, there is provided a railway electrification system comprising: an electrical power source; a supply conductor; a return conductor; a rail line; and a plurality of autotransformers, the supply conductor configured to supply electrical power from the electrical power source to a rail vehicle on the rail line, the return conductor configured to provide a current return path to the electrical power source, the rail line electrically connected to ground, each autotransformer arranged along the rail line and configured to electrically interconnect the supply conductor, return conductor and rail line, wherein the railway electrification system further comprises the apparatus of the second aspect of the invention.

The features and advantages of the apparatus of the second aspect of the invention and its embodiments apply mutatis mutandis to the railway electrification system of the third aspect of the invention. In particular, the railway electrification system may comprise the features of the apparatus of the second aspect of the invention, or may further comprise any of the optional features of the embodiments of the apparatus of the second aspect of the invention.

A preferred embodiment of the invention will now be described, by way of a non-limiting example, with reference to the accompanying drawings in which:

Figure 1 shows schematically a railway electrification system according to an embodiment of the invention; and

Figures 2 and 3 show schematically an exemplary apparatus of the railway electrification system of Figure 1.

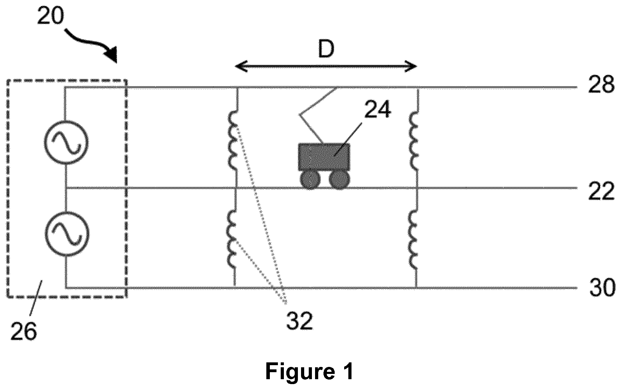

A railway electrification system is shown in Figure 1 and is designated generally by the reference numeral 20.

The railway electrification system 20 comprises an electrical power source, a supply conductor, a return conductor, a rail line 22, and a plurality of autotransformers 32. The rail line 22 lies along the surface of the ground and thereby is electrically connected to ground. In use, a rail vehicle 24 travels on the rail line 22.

The electrical power source is in the form of a feeder substation 26 connected to two phases of a three-phase AC power grid (not shown) to enable it to feed power from the AC power grid. The supply conductor is in the form of a catenary 28 that is suspended from supporting towers (not shown) that are arranged along the length of the rail line 22. The return conductor is in the form of a feeder 30 that is also suspended from the supporting towers that are arranged along the length of the rail line 22. The autotransformers 32 are spaced apart at intervals along the length of the rail line 22 to divide the railway electrification system 20 into a plurality of sections. Each autotransformer 32 is arranged to be electrically connected between the catenary 28 and feeder 30, and also electrically connected to the grounded rail line 22.

In order to power the rail vehicle 24, electrical power is supplied from the feeder substation 26 to the rail vehicle 24. A contact wire is suspended from the catenary 28 using vertical dropper wires, and the contact wire makes contact with a pantograph on top of the rail vehicle 24. This results in the formation of a current path that allows current to flow from the feeder substation 26 to the catenary 28, to the pantograph via the contact wire, to the grounded rail line 22, to each autotransformer 32, and to the feeder 30 before returning to the feeder substation 26. In this manner electrical power is supplied from the feeder substation 26 to the rail vehicle 24.

The catenary 28 is kept at a positive voltage, e.g. 25 kV, while the feeder 30 is kept at a negative voltage, e.g. - 25 kV. It is envisaged that the voltage of the catenary 28 and feeder 30 may have different values so long as a voltage drop is present across the catenary 28 and feeder 30 that permits the aforementioned circulation of current.

Meanwhile each autotransformer 32 helps to maintain the voltage drop between the catenary 28 and feeder 30 along the length of the rail line 22.

A fault may occur in the railway electrification system 20. This fault may be in the form of a catenary-to-feeder fault or a catenary-to-ground fault.

The railway electrification system 20 comprises sensors configured to measure voltage and current at the feeder substation 26. More specifically the sensors are configured to measure the voltages $u_A, u_B$ and current $i_A, i_B$ of the two phases of the AC power grid connected to the feeder substation 26.

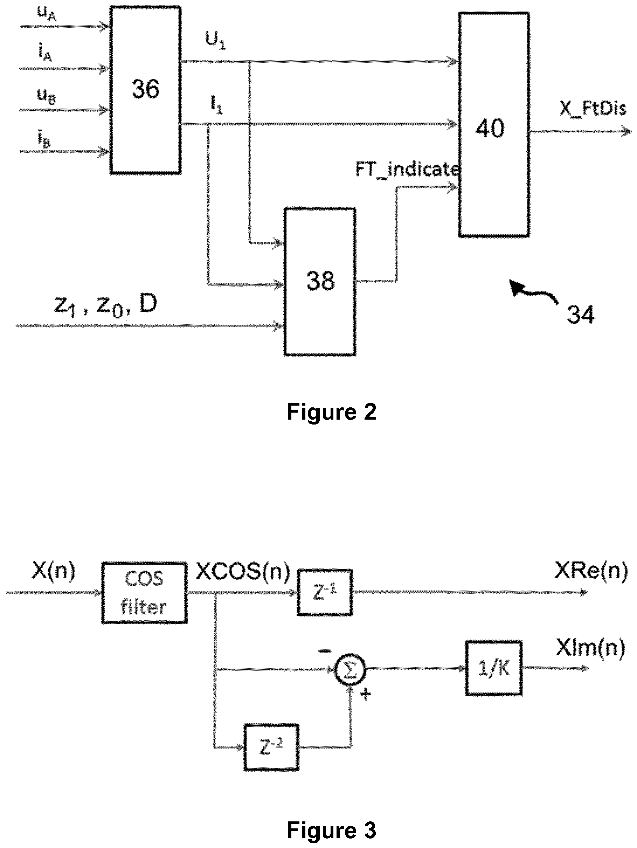

The railway electrification system 20 further comprises an apparatus 34 for identifying the type and location of the fault. The apparatus 34 includes first, second and third processing blocks 34,36,38. A block diagram of the apparatus 34 is shown in Figure 2.

In the following equations, the function *real(y)* defines taking the real part of the term *y*, and the function *imag(y)* defines taking the imaginary part of the term *y*.

The measured voltages $u_A$,$u_B$ and currents $i_A$,$i_B$ of the two phases of the AC power grid is fed into the first processing block 36, which includes a cosine filter shown in Figure 3. The first processing block 36 then derives voltage and current phasors by filtering one or more decaying direct current components from the measured voltages $u_A$,$u_B$ and currents $i_A$,$i_B$ through the following steps:

(a) processing the measured voltage and current with a cosine filter based on the following equation:

$$XCOS(n) = \frac{2}{N_{spc}} \sum_{k=1}^{N_{spc}} X(n - N_{spc} + k) \cdot \cos\left(\frac{2\pi k}{N_{spc}} - \frac{\pi}{N_{spc}}\right),$$

where $X$ is the measured voltage or current, $XCOS(n)$ is the filtered voltage or current, n is the discrete time, and $N_{spc}$ is the number of samples per cycle of fundamental frequency of the feeder substation 26;

(b) determining the real part of each phasor based on the following equation:

$$X\,\mathrm{Re}(n) = XCOS(n-1)$$

where $X\,\mathrm{Re}(n)$ is the real part of the voltage or current phasor;

(c) determining the imaginary part of each phasor based on the following

$$\text{equation: } X\,\mathrm{Im}(n) = \frac{[XCOS(n) - XCOS(n-2)]}{K}$$

where $\quad K = 2\sin\left(\dfrac{2\pi}{N_{spc}}\right)$, and $X\,\mathrm{Im}(n)$ is the imaginary part of the voltage or current phasor.

The derived voltage and current phasors are then fed into a second processing block 38. In addition the positive sequence impedance $z_1$ of the catenary 28 in ohms per length, the zero sequence impedance $z_0$ of the catenary 28 in ohms per length, and the distance D between successive autotransformers 32 arranged along the rail line 22 are also fed into the second processing block 38. The second processing block 38 then processes the received information to determine whether the fault is located between the catenary 28 and feeder 30 or between the catenary 28 and ground.

The positive-sequence impedance $z_1$ of the catenary 28 is defined as the self-impedance of the catenary 28 minus the mutual impedance between the catenary 28 and the feeder 30. The zero sequence impedance $z_0$ of the catenary 28 is defined as the self-impedance of the catenary 28 plus the mutual impedance between the catenary 28 and the feeder 30.

Firstly, the second processing block 38 determines an estimated distance of the fault from the feeder substation 26 along the catenary 28 based on the following equation:

$$x_0 = \frac{imag\left(\dfrac{\dot{U}_1}{\dot{I}_1}\right)}{imag(z_1)}$$

where $x_0$ is the estimated distance of the fault from the feeder substation 26 along the catenary 28, $\dot{U}_1$ is the voltage phasor, $\dot{I}_1$ is the current phasor, $z_1$ is the positive sequence impedance of the catenary 28 in ohms per length.

Secondly, the second processing block 38 determines an additional impedance $\Delta Z$ based on the following

equations:

$$\Delta Z_{real} = real\left(\frac{\dot{U}_1}{\dot{I}_1}\right) - real(z_1) \cdot x_0$$

$$\Delta Z_{imag} = \frac{(x_0 - ND)(ND + D - x_0)}{D} \cdot imag(z_0)$$

$$\Delta Z = \Delta Z_{real} + j \cdot \Delta Z_{imag}$$

where $\Delta Z_{real}$ is the real part of $\Delta Z$, $\Delta Z_{imag}$ is the imaginary part of $\Delta Z$, $x_0$ is the estimated distance of the fault from the feeder substation 26 along the catenary 28, $N = floor\left(\frac{x_0}{D}\right)$, the function $floor(y)$ defines giving the largest integer number less than or equal to the term $y$, $z_0$ is the zero sequence impedance of the catenary 28 in ohms per length, and D is the distance between successive autotransformers 32 arranged along the rail line 22.

Thirdly, the second processing block 38 determines a corrected distance of the fault from the feeder substation 26 along the catenary 28 based on the following equation:

$$x_1 = \frac{imag\left(\frac{\dot{U}_1}{\dot{I}_1} - \Delta Z\right)}{imag(z_1)}$$

where $x_1$ is the corrected distance of the fault from the feeder substation 26 along the catenary 28.

Fourthly, the second processing block 38 determines whether the fault is located between the catenary 28 and feeder 30 or between the catenary 28 and ground based on the following criterion:

$$\frac{real\left(\frac{\dot{U}_1}{\dot{I}_1}\right) - real(z_1) \cdot x_1}{imag\left(\frac{\dot{U}_1}{\dot{I}_1}\right) - imag(z_1) \cdot x_1} > K_{set}$$

where $K_{set}$ is the criterion threshold given by $K_{set}=ctg(arg(z_1)-5°)$.

The fault is determined to be located between the catenary 28 and ground when the ratio exceeds the criterion threshold, and wherein the fault is determined to be located between the catenary 28 and feeder 30 when the ratio does not exceed the criterion threshold. The second processing block outputs a signal FT_indicate that represents the determination of the location of the fault, and the signal FT_indicate is fed to a third processing block.

The third processing block 40 determines the distance of the fault from the feeder substation 26 along the catenary 28 based on the following equation when the fault is between the catenary 28 and ground:

$$imag(\dot{U}_1) = imag(z_1\dot{I}_1)x + \frac{(x - ND)(ND + D - x)}{D}]imag(z_0\dot{I}_1)$$

where $x$ is the distance of the fault from the feeder substation 26 along the catenary 28, $N = floor\left(\frac{x}{D}\right)$, and the function floor defines giving the largest integer number less than or equal to the term $\left(\dfrac{x}{D}\right)$.

The third processing block 40 determines the distance of the fault from the feeder substation 26 along the catenary 28 based on the following equation when the fault is located between the catenary 28 and feeder 30:

$$x = \frac{imag\left(\dfrac{\dot{U}_1}{\dot{I}_1}\right)}{imag\left(z_1\right)}$$

where $x$ is the distance of the fault from the feeder substation 26 along the catenary 28.

Finally, the third processing block 40 outputs a signal X_FtDis that represents the distance of the fault from the feeder substation 26 along the catenary 28.

The output signals FT_indicate,X_FtDis from the second and third processing blocks 36,38 may fed to a protection device which then automatically takes action to address the identified fault, or can be provided (e.g. using a display) to an operator who can then manually take action to address the identified fault.

The method of the invention therefore enables the reliable identification of the type and location of a fault in the railway electrification system 20 by utilising voltage and current phasors determined from voltage and current measured at the feeder substation 26.

Moreover the method of the invention does not require remote measurements to help identify the type and location of a fault in the railway electrification system 20. This beneficially results in a cheaper and less complex railway electrification system 20 since there is not only no need to install remote sensors along the length of the railway electrification system 20 but also no need to install and manage additional hardware associated with remote sensors, such as communication links and GPS devices.

It will be appreciated that each numerical value given for the embodiment shown is merely chosen to help illustrate the working of the invention, and may be replaced by another numerical value. It will also be appreciated that each equation given for the embodiment shown is merely chosen to help illustrate the working of the invention, and may be replaced by another equivalent equation performing the same function. It will be further appreciated that the structure of the railway electrification system 20 and the layout of the apparatus 34 shown in the accompanying figures are intended to form non-limiting examples to demonstrate the working of the invention.

**Claims**

1. A method of identifying a fault in a railway electrification system (20), the railway electrification system (20) comprising: an electrical power source (26); a supply conductor (28); a return conductor (30); a rail line (22); and a plurality of autotransformers (32), the supply conductor (28) configured to supply electrical power from the electrical power source (26) to a rail vehicle (24) on the rail line (22), the return conductor (30) configured to provide a current return path to the electrical power source (26), the rail line (22) electrically connected to ground, each autotransformer (32) arranged along the rail line (22) and configured to electrically interconnect the supply conductor (28), return conductor (30) and rail line (22), the method comprising the steps of:

   determining voltage and current phasors from voltage and current measured at the electrical power source (26);
   determining, based on the voltage and current phasors, whether the fault is located between the supply and return conductors (28,30) or between the supply conductor (28) and ground;
   determining, based on the voltage and current phasors, the location of the fault along the supply conductor (28).

2. A method according to Claim 1 wherein the determination of whether the fault is located between the supply and return conductors (28,30) or between the supply conductor (28) and ground is based on only the voltage and current phasors.

3. A method according to Claim 1 or Claim 2 wherein the determination of the location of the fault along the supply conductor (28) is based on only the voltage and current phasors.

4. A method according to any one of the preceding claims wherein the step of determining voltage and current phasors from voltage and current measured at the electrical power source (26) includes filtering one or more decaying direct current components from the measured voltage and current.

5. A method according to any one of the preceding claims wherein the step of determining voltage and current phasors from voltage and current measured at the electrical power source (26) includes:

(a) processing the measured voltage and current with a cosine filter based on the following equation:

$$XCOS(n) = \frac{2}{N_{spc}} \sum_{k=1}^{N_{spc}} X(n - N_{spc} + k) \cdot \cos(\frac{2\pi k}{N_{spc}} - \frac{\pi}{N_{spc}}),$$

where $X$ is the measured voltage or current, $XCOS(n)$ is the filtered voltage or current, n is the discrete time, and $N_{spc}$ is the number of samples per cycle of fundamental frequency of the electrical power source (26);
(b) determining the real part of each phasor based on the following equation:

$$X\,\mathrm{Re}(n) = XCOS(n-1)$$

where $X\,\mathrm{Re}(n)$ is the real part of the voltage or current phasor;
(c) determining the imaginary part of each phasor based on the following

$$\text{equation: } X\,\mathrm{Im}(n) = \frac{[XCOS(n) - XCOS(n-2)]}{K}$$

where $K = 2\sin\left(\frac{2\pi}{N_{spc}}\right)$ , and $X\,\mathrm{Im}(n)$ is the imaginary part of the voltage or current phasor.

6. A method according to any one of the preceding claims wherein the step of determining, based on the voltage and current phasors, whether the fault is located between the supply and return conductors (28,30) or between the supply conductor (28) and ground includes:

(a) determining an estimated distance of the fault from the electrical power source (26) along the supply conductor (28) based on the voltage and current phasors and the positive sequence impedance ($z_1$) of the supply conductor (28) in ohms per length;
(b) determining an additional impedance ($\Delta Z$) based on the voltage and current phasors, the positive sequence impedance ($z_1$) of the supply conductor (28) in ohms per length, the estimated distance of the fault from the electrical power source (26) along the supply conductor (28), the zero-sequence impedance ($z_0$) of the supply conductor (28) in ohms per length, and the distance (D) between successive autotransformers (32) arranged along the rail line (22);
(c) determining a corrected distance of the fault from the electrical power source (26) along the supply conductor (28) based on the additional impedance ($\Delta Z$), the voltage and current phasors and the positive sequence impedance ($z_1$) of the supply conductor (28) in ohms per length;
(d) determining whether the fault is located between the supply and return conductors (28,30) or between the supply conductor (28) and ground by comparing the ratio of first and second values against a criterion threshold, wherein the first value is based on the corrected distance and the real parts of the voltage and current phasors and the positive sequence impedance ($z_1$) of the supply conductor (28) in ohms per length, and the second value is based on the corrected distance and the imaginary parts of the voltage and current phasors and the positive sequence impedance ($z_1$) of the supply conductor (28) in ohms per length, wherein the fault is determined to be located between the supply conductor (28) and ground when the ratio exceeds the criterion threshold, and wherein the fault is determined to be located between the supply and return conductors (28,30) when the ratio does not exceed the criterion threshold.

7. A method according to Claim 6 wherein the estimated distance of the fault from the electrical power source (26) along the supply conductor (28) is determined based on the following equation:

$$x_0 = \frac{imag\left(\dfrac{\dot{U}_1}{\dot{I}_1}\right)}{imag\,(z_1)}$$

where $x_0$ is the estimated distance of the fault from the electrical power source (26) along the supply conductor (28), $\dot{U}_1$ is the voltage phasor, $\dot{I}_1$ is the current phasor, $z_1$ is the positive sequence impedance of the supply conductor (28) in ohms per length, and the function $imag(y)$ defines taking the imaginary part of the term $y$.

8. A method according to Claim 6 or Claim 7 wherein the additional impedance is determined based on the following equations:

$$\Delta Z_{real} = real\left(\frac{\dot{U}_1}{\dot{I}_1}\right) - real\,(z_1)\cdot x_0$$

$$\Delta Z_{imag} = \frac{(x_0 - ND)(ND + D - x_0)}{D}\cdot imag\,(z_0)$$

$$\Delta Z = \Delta Z_{real} + j\cdot \Delta Z_{imag}$$

where $\Delta Z$ is the additional impedance, $\Delta Z_{real}$ is the real part of $\Delta Z$, $\Delta Z_{imag}$ is the imaginary part of $\Delta Z$, $\dot{U}_1$ is the voltage phasor, $\dot{I}_1$ is the current phasor, $z_1$ is the positive sequence impedance of the supply conductor (28) in ohms per length, $x_0$ is the estimated distance of the fault from the electrical power source (26) along the supply conductor (28), the function $real(y)$ defines taking the real part of the term $y$, $N = floor\left(\dfrac{x_0}{D}\right)$, the function $floor(y)$ defines giving the largest integer number less than or equal to the term $y$, $z_0$ is the zero sequence impedance of the supply conductor (28) in ohms per length, the function $imag(y)$ defines taking the imaginary part of the term $y$, and $D$ is the distance between successive autotransformers (32) arranged along the rail line (22).

9. A method according to any one of Claims 6 to 8 wherein the corrected distance of the fault from the electrical power source (26) along the supply conductor (28) is determined based on the following equation:

$$x_1 = \frac{imag\left(\dfrac{\dot{U}_1}{\dot{I}_1} - \Delta Z\right)}{imag\,(z_1)}$$

Where $x_1$ is the corrected distance of the fault from the electrical power source (26) along the supply conductor (28), $\dot{U}_1$ is the voltage phasor, $\dot{I}_1$ is the current phasor, $\Delta Z$ is the additional impedance, $z_1$ is the positive sequence impedance of the supply conductor (28) in ohms per length, and the function $imag(y)$ defines taking the imaginary part of the term $y$.

10. A method according to any one of Claims 6 to 9 wherein the determination of whether the fault is located between the supply and return conductors (28,30) or between the supply conductor (28) and ground is based on the following criterion:

$$\frac{real\left(\dfrac{\dot{U}_1}{\dot{I}_1}\right) - real(z_1)\cdot x_1}{imag\left(\dfrac{\dot{U}_1}{\dot{I}_1}\right) - imag(z_1)\cdot x_1} > K_{set}$$

where $\dot{U}_1$ is the voltage phasor, $\dot{I}_1$ is the current phasor, $z_1$ is the positive sequence impedance of the supply conductor (28) in ohms per length, $x_1$ is the corrected distance of the fault from the electrical power source (26) along the supply conductor (28), the function $real(y)$ defines taking the real part of the term $y$, the function $imag(y)$ defines taking the imaginary part of the term $y$, and $K_{set}$ is the criterion threshold,

wherein the fault is determined to be located between the supply conductor (28) and ground when the ratio exceeds the criterion threshold, and wherein the fault is determined to be located between the supply and return conductors (28,30) when the ratio does not exceed the criterion threshold.

11. A method according to Claim 10 wherein the criterion threshold is given by $K_{set} = ctg$ (arg $(z_1)$-5°).

12. A method according to any one of the preceding claims wherein the step of determining, based on the voltage and current phasors, the location of the fault along the supply conductor (28) includes determining the distance of the fault from the electrical power source (26) along the supply conductor (28) based on the imaginary parts of the voltage and current phasors and the impedance of the supply conductor (28) in ohms per length.

13. A method according to Claim 12 wherein the distance of the fault from the electrical power source (26) along the supply conductor (28) is determined based on the following equation when the fault is between the supply conductor (28) and ground:

$$imag\,(\dot{U}_1) = imag\,(z_1\dot{I}_1)x + \frac{(x-ND)(ND+D-x)}{D}]imag\,(z_0\dot{I}_1)$$

where $x$ is the distance of the fault from the electrical power source (26) along the supply conductor (28), $\dot{U}_1$ is the voltage phasor, $\dot{I}_1$ is the current phasor, $z_1$ is the positive sequence impedance of the supply conductor (28) in ohms per length, $N = floor\left(\dfrac{x}{D}\right)$ , the function floor defines giving the largest integer number less than or equal to

the term $\left(\dfrac{x}{D}\right)$ , $D$ is the distance between successive autotransformers (32) along the rail line (22); $z_0$ is the zero sequence impedance of the supply conductor (28) in ohms per length, and the function $imag\,(y)$ defines taking the imaginary part of the term y.

14. A method according to Claim 12 or Claim 13 wherein the distance of the fault from the electrical power source (26) along the supply conductor (28) is determined based on the following equation when the fault is located between the supply and return conductors (28,30):

$$x = \frac{imag\left(\dfrac{\dot{U}_1}{\dot{I}_1}\right)}{imag\,(z_1)}$$

where $x$ is the distance of the fault from the electrical power source (26) along the supply conductor (28), $\dot{U}_1$ is the voltage phasor, $\dot{I}_1$ is the current phasor, $z_1$ is the positive sequence impedance of the supply conductor (28) in ohms per length, and the function $imag(y)$ defines taking the imaginary part of the term y.

**15.** An apparatus (34) for locating a fault in a railway electrification system (20), the railway electrification system (20) comprising: an electrical power source (26); a supply conductor (28); a return conductor (30); a rail line (22); and a plurality of autotransformers (32), the supply conductor (28) configured to supply electrical power from the electrical power source (26) to a rail vehicle (24) on the rail line (22), the return conductor (30) configured to provide a current return path to the electrical power source (26), the rail line (22) electrically connected to ground, each autotransformer (32) arranged along the rail line (22) and configured to electrically interconnect the supply conductor (28), return conductor (30) and rail line (22), the apparatus (34) configured to:

determine voltage and current phasors from voltage and current measured at the electrical power source (26);
determine, based on the voltage and current phasors, whether the fault is located between the supply and return conductors (28,30) or between the supply conductor (28) and ground;
determine, based on the voltage and current phasors, the location of the fault along the supply conductor (28).

**Patentansprüche**

**1.** Verfahren zum Identifizieren eines Fehlers in einem Schienenelektrifizierungssystem (20), wobei das Schienenelektrifizierungssystem (20) umfasst: eine elektrische Stromquelle (26); einen Zuleiter (28); einen Ableiter (30); einen Schienenweg (22); und eine Vielzahl von Autotransformatoren (32), wobei der Zuleiter (28) dazu ausgebildet ist, elektrischen Strom von der elektrischen Stromquelle (26) zu einem Schienenfahrzeug (24) auf dem Schienenweg (22) zuzuleiten, der Ableiter (30) dazu ausgebildet ist, einen Stromableitpfad zu der elektrischen Stromquelle (26) bereitzustellen, der Schienenweg (22) elektrisch mit Masse verbunden ist, jeder Autotransformator (32) entlang des Schienenwegs (22) eingerichtet ist und dazu ausgebildet ist, den Zuleiter (28), Ableiter (30) und Schienenweg (22) elektrisch miteinander zu verbinden, wobei das Verfahren die Schritte umfasst:

Ermitteln von Spannungs- und Stromstärkephasoren aus Spannung und Stromstärke, die bei der elektrischen Stromquelle (26) gemessen werden;
Ermitteln, basierend auf den Spannungs- und Stromstärkephasoren, ob der Fehler zwischen dem Zu- und Ableiter (28,30) oder zwischen dem Zuleiter (28) und Masse liegt;
Ermitteln, basierend auf den Spannungs- und Stromstärkephasoren, der Stelle des Fehlers entlang des Zuleiters (28).

**2.** Verfahren nach Anspruch 1, wobei die Ermittlung, ob der Fehler zwischen dem Zu- und Ableiter (28,30) oder zwischen dem Zuleiter (28) und Masse liegt, nur auf den Spannungs- und Stromstärkephasoren basiert.

**3.** Verfahren nach Anspruch 1 oder Anspruch 2, wobei die Ermittlung der Stelle des Fehlers entlang des Zuleiters (28) nur auf den Spannungs- und Stromstärkephasoren basiert.

**4.** Verfahren nach einem der vorstehenden Ansprüche, wobei der Schritt zum Ermitteln von Spannungs- und Stromstärkephasoren aus Spannung und Stromstärke, die bei der elektrischen Stromquelle (26) gemessen werden, beinhaltet, eine oder mehrere abfallende Gleichstromkomponenten aus der gemessenen Spannung und Stromstärke zu filtern.

**5.** Verfahren nach einem der vorstehenden Ansprüche, wobei der Schritt zum Ermitteln von Spannungs- und Stromstärkephasoren aus Spannung und Stromstärke, die bei der elektrischen Stromquelle (26) gemessen wird, beinhaltet:

(a) Verarbeiten der gemessenen Spannung und Stromstärke mit einem Cosinus-Filter, basierend auf der folgenden Gleichung:

$$XCOS(n) = \frac{2}{N_{spc}} \sum_{k=1}^{N_{spc}} X(n - N_{spc} + k) \cdot \cos\left(\frac{2\pi k}{N_{spc}} - \frac{\pi}{N_{spc}}\right),$$

wo $X$ die gemessene Spannung oder Stromstärke ist, $XCOS(n)$ die gefilterte Spannung oder Stromstärke ist, n die diskrete Zeit ist, und $N_{spc}$ die Zahl von Abtastungen pro Zyklus fundamentaler Frequenz der elektrischen Stromquelle (26) ist;
(b) Ermitteln des realen Teils jedes Phasors, basierend auf der folgenden Gleichung:

$$X \operatorname{Re}(n) = XCOS(n-1)$$

wo $X\operatorname{Re}(n)$ der reale Teil des Spannungs- oder Stromstärkephasors ist;

(c) Ermitteln des imaginären Teils jedes Phasors, basierend auf der folgenden Gleichung:

$$X \operatorname{Im}(n) = \frac{[XCOS(n) - XCOS(n-2)]}{K}$$

wo $K = 2\sin\left(\frac{2\pi}{N_{spc}}\right)$ ist und $X\operatorname{Im}(n)$ der imaginäre Teil des Spannungs- oder Stromstärkephasors ist.

**6.** Verfahren nach einem der vorstehenden Ansprüche, wobei der Schritt zum Ermitteln, basierend auf den Spannungs- und Stromstärkephasoren, ob der Fehler zwischen dem Zu- und Ableiter (28,30) oder zwischen dem Zuleiter (28) und Masse liegt, beinhaltet:

(a) Ermitteln eines geschätzten Abstands des Fehlers von der elektrischen Stromquelle (26) entlang des Zuleiters (28), basierend auf den Spannungs- und Stromstärkephasoren und der positiven Sequenzimpedanz ($z_1$) des Zuleiters (28) in Ohm pro Länge;

(b) Ermitteln einer zusätzlichen Impedanz ($\Delta Z$), basierend auf den Spannungs- und Stromstärkephasoren, der positiven Sequenzimpedanz ($z_1$) des Zuleiters (28) in Ohm pro Länge, des geschätzten Abstands des Fehlers von der elektrischen Stromquelle (26) entlang des Zuleiters (28), der Nullsequenzimpedanz ($z_0$) des Zuleiters (28) in Ohm pro Länge und des Abstands (D) zwischen aufeinanderfolgenden Autotransformatoren (32), die entlang des Schienenwegs (22) eingerichtet sind;

(c) Ermitteln eines korrigierten Abstands des Fehlers von der elektrischen Stromquelle (26) entlang des Zuleiters (28), basierend auf der zusätzlichen Impedanz ($\Delta Z$), der Spannungs- und Stromstärkephasoren und der positiven Sequenzimpedanz ($z_1$) des Zuleiters (28) in Ohm pro Länge;

(d) Ermitteln, ob der Fehler zwischen dem Zu- und Ableiter (28,30) oder zwischen dem Zuleiter (28) und Masse liegt, indem das Verhältnis erster und zweiter Werte mit einer Kriterienschwelle verglichen wird, wobei der erste Wert auf dem korrigierten Abstand und den realen Teilen der Spannungs- und Stromstärkephasoren und der positiven Sequenzimpedanz ($z_1$) des Zuleiters (28) in Ohm pro Länge basiert, und der zweite Wert auf dem korrigierten Abstand und den imaginären Teilen der Spannungs- und Stromstärkephasoren und der positiven Sequenzimpedanz ($z_1$) des Zuleiters (28) in Ohm pro Länge basiert, wobei der Fehler ermittelt wird, zwischen dem Zuleiter (28) und Masse zu liegen, wenn das Verhältnis die Kriterienschwelle übersteigt, und wobei der Fehler ermittelt wird, zwischen dem Zu- und Ableiter (28,30) zu liegen, wenn das Verhältnis die Kriterienschwelle nicht übersteigt.

**7.** Verfahren nach Anspruch 6, wobei der geschätzte Abstand des Fehlers von der elektrischen Stromquelle (26) entlang des Zuleiters (28) basierend auf der folgenden Gleichung ermittelt wird:

$$x_0 = \frac{imag\left(\frac{\dot{U}_1}{\dot{I}_1}\right)}{imag(z_1)}$$

wo $x_0$ der geschätzte Abstand des Fehlers von der elektrischen Stromquelle (26) entlang des Zuleiters (28) ist, $\dot{U}_1$ der Spannungsphasor ist, $\dot{I}_1$ der Stromstärkephasor ist, $z_1$ die positive Sequenzimpedanz des Zuleiters (28) in Ohm pro Länge ist, und die Funktion $imag(y)$ den imaginären Teil des Ausdrucks $y$ definiert.

**8.** Verfahren nach Anspruch 6 oder Anspruch 7, wobei die zusätzliche Impedanz basierend auf den folgenden Gleichungen ermittelt wird:

$$\Delta Z_{real} = real\left(\frac{\dot{U}_1}{\dot{I}_1}\right) - real(z_1) \cdot x_0$$

$$\Delta Z_{imag} = \frac{(x_0 - ND)(ND + D - x_0)}{D} \cdot imag(z_0)$$

$$\Delta Z = \Delta Z_{real} + j \cdot \Delta Z_{imag}$$

wo $\Delta Z$ die zusätzliche Impedanz ist, $\Delta Z_{real}$ der reale Teil von $\Delta Z$ ist, $\Delta Z_{imag}$ der imaginäre Teil von $\Delta Z$ ist, $\dot{U}_1$ der Spannungsphasor ist, $\dot{I}_1$ der Stromstärkephasor ist, $z_1$ die positive Sequenzimpedanz des Zuleiters (28) in Ohm pro Länge ist, $x_0$ der geschätzte Abstand des Fehlers von der elektrischen Stromquelle (26) entlang des Zuleiters (28) ist, die Funktion $real(y)$ den realen Teil des Ausdrucks $y$, $N = floor\left(\frac{x_0}{D}\right)$ definiert, die Funktion $floor(y)$ die größte Ganzzahl definiert, die kleiner als oder gleich dem Ausdruck $y$ ist, $z_0$ die Nullsequenzimpedanz des Zuleiters (28) in Ohm pro Länge ist, die Funktion $imag(y)$ den imaginären Teil des Ausdrucks $y$ definiert, und $D$ der Abstand zwischen aufeinanderfolgenden Autotransformatoren (32) ist, die entlang des Schienenwegs (22) eingerichtet sind.

**9.** Verfahren nach einem der Ansprüche 6 bis 8, wobei der korrigierte Abstand des Fehlers von der elektrischen Stromquelle (26) entlang des Zuleiters (28) basierend auf der folgenden Gleichung ermittelt wird:

$$x_1 = \frac{imag\left(\frac{\dot{U}_1}{\dot{I}_1} - \Delta Z\right)}{imag(z_1)}$$

Wo x1 der korrigierte Abstand des Fehlers von der elektrischen Stromquelle (26) entlang des Zuleiters (28) ist, $\dot{U}_1$ der Spannungsphasor ist, $\dot{I}_1$ 7 der Stromstärkephasor ist, $\Delta Z$ die zusätzliche Impedanz ist, $z_1$ die positive Sequenzimpedanz des Zuleiters (28) in Ohm pro Länge ist, und die Funktion $imag(y)$ den imaginären Teil des Ausdrucks $y$ definiert.

**10.** Verfahren nach einem der Ansprüche 6 bis 9, wobei die Ermittlung dessen, ob der Fehler zwischen dem Zu- und Ableiter (28,30) oder zwischen dem Zuleiter (28) und Masse liegt, auf dem folgenden Kriterium basiert:

$$\frac{real\left(\frac{\dot{U}_1}{\dot{I}_1}\right) - real(z_1) \cdot x_1}{imag\left(\frac{\dot{U}_1}{\dot{I}_1}\right) - imag(z_1) \cdot x_1} > K_{set}$$

wo $\dot{U}_1$ der Spannungsphasor ist, $\dot{I}_1$ der Stromstärkephasor ist, $z_1$ die positive Sequenzimpedanz des Zuleiters (28) in Ohm pro Länge ist, $x1$ der korrigierte Abstand des Fehlers von der elektrischen Stromquelle (26) entlang des Zuleiters (28) ist, die Funktion $real(y)$ den realen Teil des Ausdrucks $y$ definiert, die Funktion $imag(y)$ den imaginären Teil des Ausdrucks $y$ definiert und $K_{set}$ die Kriterienschwelle ist,

wobei der Fehler ermittelt wird, zwischen dem Zuleiter (28) und Masse zu liegen, wenn das Verhältnis die Kriterienschwelle übersteigt, und wobei der Fehler ermittelt wird, zwischen dem Zu- und Ableiter (28,30) zu liegen, wenn das Verhältnis die Kriterienschwelle nicht übersteigt.

**11.** Verfahren nach Anspruch 10, wobei die Kriterienschwelle durch Folgendes

$$K_{set} = ctg\left(arg(z_1) - 5°\right).$$

angegeben wird

**12.** Verfahren nach einem der vorstehenden Ansprüche, wobei der Schritt zum Ermitteln, basierend auf den Spannungs- und Stromstärkephasoren, der Stelle des Fehlers entlang des Zuleiters (28) beinhaltet, den Abstand des Fehlers von der elektrischen Stromquelle (26) entlang des Zuleiters (28) basierend auf den imaginären Teilen der Spannungs- und Stromstärkephasoren und der Impedanz des Zuleiters (28) in Ohm pro Länge zu ermitteln.

**13.** Verfahren nach Anspruch 12, wobei der Abstand des Fehlers von der elektrischen Stromquelle (26) entlang des Zuleiters (28) basierend auf der folgenden Gleichung ermittelt wird, wenn der Fehler zwischen dem Zuleiter (28) und Masse ist:

$$imag\,(\dot{U}_1) = imag\,(z_1\dot{I}_1)x + \frac{(x - ND)(ND + D - x)}{D}]imag\,(z_0\dot{I}_1)$$

wo $x$ der Abstand des Fehlers von der elektrischen Stromquelle (26) entlang des Zuleiters (28) ist, $\dot{U}_1$ der Spannungsphasor ist, $\dot{I}_1$ der Stromstärkephasor ist, $z_1$ die positive Sequenzimpedanz des Zuleiters (28) in Ohm pro

$$N = floor\left(\frac{x}{D}\right)$$

Länge ist, , die untere Gaußklammer der Funktion die größte Zahl definiert, die kleiner als oder gleich dem Ausdruck $\left(\frac{x}{D}\right)$ ist, $D$ der Abstand zwischen aufeinanderfolgenden Autotransformatoren (32) entlang des Schienenwegs (22) ist; $z_0$ die Nullsequenzimpedanz des Zuleiters (28) in Ohm pro Länge ist, und die Funktion $imag(y)$ den imaginären Teil des Ausdrucks $y$ definiert.

**14.** Verfahren nach Anspruch 12 oder Anspruch 13, wobei der Abstand des Fehlers von der elektrischen Stromquelle (26) entlang des Zuleiters (28) basierend auf der folgenden Gleichung ermittelt wird, wenn der Fehler zwischen dem Zu- und Ableiter (28,30) liegt:

$$x = \frac{imag\left(\frac{\dot{U}_1}{\dot{I}_1}\right)}{imag\,(z_1)}$$

wo $x$ der Abstand des Fehlers von der elektrischen Stromquelle (26) entlang des Zuleiters (28) ist, $\dot{U}_1$ der Spannungsphasor ist, $\dot{I}_1$ der Stromstärkephasor ist, $z_1$ die positive Sequenzimpedanz des Zuleiters (28) in Ohm pro Länge ist, und die Funktion $imag(y)$ den imaginären Teil des Ausdrucks $y$ definiert.

**15.** Einrichtung (34) zum Lokalisieren eines Fehlers in einem Schienenelektrifizierungssystem (20), wobei das Schienenelektrifizierungssystem (20) umfasst: eine elektrische Stromquelle (26); einen Zuleiter (28); einen Ableiter (30); einen Schienenweg (22); und eine Vielzahl von Autotransformatoren (32), wobei der Zuleiter (28) dazu ausgebildet ist, elektrischen Strom von der elektrischen Stromquelle (26) zu einem Schienenfahrzeug (24) auf dem Schienenweg (22) zuzuleiten, der Ableiter (30) dazu ausgebildet ist, einen Stromableitpfad zu der elektrischen Stromquelle (26) bereitzustellen, der Schienenweg (22) elektrisch mit Masse verbunden ist, jeder Autotransformator (32) entlang des Schienenwegs (22) eingerichtet ist und dazu ausgebildet ist, den Zuleiter (28), Ableiter (30) und Schienenweg (22) elektrisch miteinander zu verbinden, wobei die Einrichtung (34) für Folgendes ausgebildet ist:

Ermitteln von Spannungs- und Stromstärkephasoren aus Spannung und Stromstärke, die bei der elektrischen Stromquelle (26) gemessen werden;
Ermitteln, basierend auf den Spannungs- und Stromstärkephasoren, ob der Fehler zwischen dem Zu- und Ableiter (28,30) oder zwischen dem Zuleiter (28) und Masse liegt;
Ermitteln, basierend auf den Spannungs- und Stromstärkephasoren, der Stelle des Fehlers entlang des Zuleiters (28).

**Revendications**

1. Procédé d'identification d'un défaut dans un système d'électrification ferroviaire (20), le système d'électrification ferroviaire (20) comprenant : une source d'énergie électrique (26) ; un conducteur de distribution (28) ; un conducteur de retour (30) ; une ligne ferroviaire (22) ; et une pluralité d'autotransformateurs (32), le conducteur de distribution (28) étant configuré pour distribuer de l'énergie électrique de la source d'énergie électrique (26) à un véhicule ferroviaire (24) sur la ligne ferroviaire (22), le conducteur de retour (30) étant configuré pour fournir une voie de retour de courant à la source d'énergie électrique (26), la ligne ferroviaire (22) étant électriquement reliée à la terre, chaque autotransformateur (32) étant agencé le long de la ligne ferroviaire (22) et configuré pour interconnecter électriquement le conducteur de distribution (28), le conducteur de retour (30) et la ligne ferroviaire (22), le procédé comprenant les étapes suivantes :

   la détermination de phaseurs de tension et de courant à partir d'une tension et d'un courant mesurés au niveau de la source d'énergie électrique (26) ;
   la détermination, sur la base des phaseurs de tension et de courant, si le défaut est situé entre les conducteurs de distribution et de retour (28, 30) ou entre le conducteur de distribution (28) et la terre ;
   la détermination, sur la base des phaseurs de tension et de courant, de l'emplacement du défaut le long du conducteur de distribution (28).

2. Procédé selon la revendication 1, dans lequel la détermination si le défaut est situé entre les conducteurs de distribution et de retour (28, 30) ou entre le conducteur de distribution (28) et la terre est basée uniquement sur les phaseurs de tension et de courant.

3. Procédé selon la revendication 1 ou 2, dans lequel la détermination de l'emplacement du défaut le long du conducteur de distribution (28) est basée uniquement sur les phaseurs de tension et de courant.

4. Procédé selon l'une quelconque des revendications précédentes, dans lequel l'étape de la détermination de phaseurs de tension et de courant à partir d'une tension et d'un courant mesurés au niveau de la source d'énergie électrique (26) inclut le filtrage d'une ou plusieurs composantes de courant continu décroissantes de la tension et du courant mesurés.

5. Procédé selon l'une quelconque des revendications précédentes, dans lequel l'étape de la détermination de phaseurs de tension et de courant à partir d'une tension et d'un courant mesurés au niveau de la source d'énergie électrique (26) inclut :

   (a) le traitement de la tension et du courant mesurés avec un filtre cosinusoïdal sur la base de l'équation suivante :

   $$XCOS(n) = \frac{2}{N_{spc}} \sum_{k=1}^{N_{spc}} X(n - N_{spc} + k) \cdot \cos(\frac{2\pi k}{N_{spc}} - \frac{\pi}{N_{spc}}),$$

   où $X$ est la tension ou le courant mesuré, $XCOS(n)$ est la tension ou le courant filtré, n est le temps discret, et $N_{spc}$ est le nombre d'échantillons par cycle de fréquence fondamentale de la source d'énergie électrique (26) ;
   (b) la détermination de la partie réelle de chaque phaseur sur la base de l'équation suivante :

   $$X\,\mathrm{Re}(n) = XCOS(n-1)$$

   où $X\,\mathrm{Re}(n)$ est la partie réelle du phaseur de tension ou de courant ;
   (c) la détermination de la partie imaginaire de chaque phaseur sur la base de l'équation suivante :

   $$X\,\mathrm{Im}(n) = \frac{[XCOS(n) - XCOS(n-2)]}{K}$$

$$K = 2\sin\left(\frac{2\pi}{N_{spc}}\right)$$

ou , et $X\,\mathrm{Im}(n)$ est la partie imaginaire du phaseur de tension ou de courant.

**6.** Procédé selon l'une quelconque des revendications précédentes, dans lequel l'étape de la détermination, sur la base des phaseurs de tension et de courant, si le défaut est situé entre les conducteurs de distribution et de retour (28, 30) ou entre le conducteur de distribution (28) et la terre inclut :

(a) la détermination d'une distance estimée du défaut depuis la source d'énergie électrique (26) le long du conducteur de distribution (28) sur la base des phaseurs de tension et de courant et de l'impédance de séquence positive ($z_1$) du conducteur de distribution (28) en ohms par longueur ;

(b) la détermination d'une impédance supplémentaire ($\Delta Z$) sur la base des phaseurs de tension et de courant, de l'impédance de séquence positive ($z_1$) du conducteur de distribution (28) en ohms par longueur, de la distance estimée du défaut depuis la source d'énergie électrique (26) le long du conducteur de distribution (28), de l'impédance de séquence nulle ($z_0$) du conducteur de distribution (28) en ohms par longueur, et de la distance (D) entre des autotransformateurs successifs (32) agencés le long de la ligne ferroviaire (22) ;

(c) la détermination d'une distance corrigée du défaut depuis la source d'énergie électrique (26) le long du conducteur de distribution (28) sur la base de l'impédance supplémentaire ($\Delta Z$), des phaseurs de tension et de courant et de l'impédance de séquence positive ($z_1$) du conducteur de distribution (28) en ohms par longueur ;

(d) la détermination si le défaut est situé entre les conducteurs de distribution et de retour (28, 30) ou entre le conducteur de distribution (28) et la terre par la comparaison du rapport de première et deuxième valeurs à un seuil de critère, dans lequel la première valeur est basée sur la distance corrigée et les parties réelles des phaseurs de tension et de courant et l'impédance de séquence positive ($z_1$) du conducteur de distribution (28) en ohms par longueur, et la deuxième valeur est basée sur la distance corrigée et les parties imaginaires des phaseurs de tension et de courant et l'impédance de séquence positive ($z_1$) du conducteur de distribution (28) en ohms par longueur, dans lequel il est déterminé que le défaut se trouve entre le conducteur de distribution (28) et la terre lorsque le rapport dépasse le seuil de critère, et dans lequel il est déterminé que le défaut se trouve entre les conducteurs de distribution et de retour (28, 30) lorsque le rapport ne dépasse pas le seuil de critère.

**7.** Procédé selon la revendication 6, dans lequel la distance estimée du défaut depuis la source d'énergie électrique (26) le long du conducteur de distribution (28) est déterminée sur la base de l'équation suivante :

$$x_0 = \frac{imag\left(\dfrac{\dot{U}_1}{\dot{I}_1}\right)}{imag\,(z_1)}$$

où $x_0$ est la distance estimée du défaut depuis la source d'énergie électrique (26) le long du conducteur de distribution (28), $\dot{U}_1$ est le phaseur de tension, $\dot{I}_1$ est le phaseur de courant, $z_1$ est l'impédance de séquence positive du conducteur de distribution (28) en ohms par longueur, et la fonction *imag (y)* définit la prise de la partie imaginaire du terme *y*.

**8.** Procédé selon la revendication 6 ou 7, dans lequel l'impédance supplémentaire est déterminée sur la base des équations suivantes :

$$\Delta Z_{real} = real\left(\frac{\dot{U}_1}{\dot{I}_1}\right) - real(z_1)\cdot x_0$$

$$\Delta Z_{imag} = \frac{(x_0 - ND)(ND + D - x_0)}{D}\cdot imag\,(z_0)$$

$$\Delta Z = \Delta Z_{real} + j\cdot \Delta Z_{imag}$$

où $\Delta Z$ est l'impédance supplémentaire, $\Delta Z_{real}$ est la partie réelle de $\Delta Z$, $\Delta Z_{imag}$ est la partie imaginaire de $\Delta Z$, $\dot{U}_1$ est le phaseur de tension, $i_1$ est le phaseur de courant, $z_1$ est l'impédance de séquence positive du conducteur de distribution (28) en ohms par longueur, $x_0$ est la distance estimée du défaut depuis la source d'énergie électrique (26) le long du conducteur de distribution (28), la fonction *real(y)* définit la prise de la partie réelle du terme $y$,

$$N = floor\left(\frac{x_0}{D}\right)$$

, la fonction *floor(y)* définit de donner le plus grand nombre entier inférieur ou égal au terme $y$, $z_0$ est l'impédance de séquence positive du conducteur de distribution (28) en ohms par longueur, la fonction *imag(y)* définit la prise de la partie imaginaire du terme $y$, et $D$ est la distance entre des autotransformateurs successifs (32) agencés le long de la ligne ferroviaire (22).

9. Procédé selon l'une quelconque des revendications 6 à 8, dans lequel la distance corrigée du défaut depuis la source d'énergie électrique (26) le long du conducteur de distribution (28) est déterminée sur la base de l'équation suivante :

$$x_1 = \frac{imag\left(\frac{\dot{U}_1}{\dot{I}_1} - \Delta Z\right)}{imag(z_1)}$$

où $x_1$ est la distance corrigée du défaut depuis la source d'énergie électrique (26) le long du conducteur de distribution (28), $\dot{U}_1$ est le phaseur de tension, $i_1$ 7, est le phaseur de courant, $\Delta Z$ est l'impédance supplémentaire, $z_1$ est l'impédance de séquence positive du conducteur de distribution (28) en ohms par longueur, et la fonction *imag(y)* définit la prise de la partie imaginaire du terme $y$.

10. Procédé selon l'une quelconque des revendications 6 à 9, dans lequel la détermination si le défaut est situé entre les conducteurs de distribution et de retour (28, 30) ou entre le conducteur de distribution (28) et la terre est basée sur le critère suivant :

$$\frac{real\left(\frac{\dot{U}_1}{\dot{i}_1}\right) - real(z_1) \cdot x_1}{imag\left(\frac{\dot{U}_1}{\dot{i}_1}\right) - imag(z_1) \cdot x_1} > K_{set}$$

où $\dot{U}_1$ est le phaseur de tension, $\dot{i}_1$ est le phaseur de courant, $z_1$ est l'impédance de séquence positive du conducteur de distribution (28) en ohms par longueur, $x_1$ est la distance corrigée du défaut depuis la source d'énergie électrique (26) le long du conducteur de distribution (28), la fonction *real(y)* définit la prise de la partie réelle du terme $y$, la fonction *imag(y)* définit la prise de la partie imaginaire du terme $y$, et $K_{set}$ est le seuil de critère,
dans lequel il est déterminé que le défaut se trouve entre le conducteur de distribution (28) et la terre lorsque le rapport dépasse le seuil de critère, et dans lequel il est déterminé que le défaut se trouve entre les conducteurs de distribution et de retour (28, 30) lorsque le rapport ne dépasse pas le seuil de critère.

11. Procédé selon la revendication 10, dans lequel le seuil de critère est donné par

$$K_{set} = ctg\left(arg(z_1) - 5°\right).$$

12. Procédé selon l'une quelconque des revendications précédentes, dans lequel l'étape de la détermination, sur la base des phaseurs de tension et de courant, de l'emplacement du défaut le long du conducteur de distribution (28) inclut la détermination de la distance du défaut depuis la source d'énergie électrique (26) le long du conducteur de distribution (28) sur la base des parties imaginaires des phaseurs de tension et de courant et de l'impédance du conducteur de distribution (28) en ohms par longueur.

**13.** Procédé selon la revendication 12, dans lequel la distance du défaut depuis la source d'énergie électrique (26) le long du conducteur de distribution (28) est déterminée sur la base de l'équation suivante lorsque le défaut est entre le conducteur de distribution (28) et la terre :

$$imag(\dot{U}_1) = imag(z_1\dot{I}_1)x + \frac{(x - ND)(ND + D - x)}{D}]imag(z_0\dot{I}_1)$$

où $x$ est la distance du défaut depuis la source d'énergie électrique (26) le long du conducteur de distribution (28), $\dot{U}_1$ est le phaseur de tension, $\dot{I}_1$ est le phaseur de courant, $z_1$ est l'impédance de séquence positive du conducteur

$$N = floor\left(\frac{x}{D}\right)$$

de distribution (28) en ohms par longueur, , la fonction floor définit de donner le plus grand nombre entier inférieur ou égal au terme $\left(\frac{x}{D}\right)$ , D est la distance entre des autotransformateurs successifs (32) le long de la ligne ferroviaire (22) ; $z_0$ est l'impédance de séquence nulle du conducteur de distribution (28) en ohms par longueur, et la fonction *imag(y)* définit la prise de la partie imaginaire du terme *y*.

**14.** Procédé selon la revendication 12 ou 13, dans lequel la distance du défaut depuis la source d'énergie électrique (26) le long du conducteur de distribution (28) est déterminée sur la base de l'équation suivante lorsque le défaut se trouve entre les conducteurs de distribution et de retour (28, 30) :

$$x = \frac{imag\left(\frac{\dot{U}_1}{\dot{I}_1}\right)}{imag(z_1)}$$

où $x$ est la distance du défaut depuis la source d'énergie électrique (26) le long du conducteur de distribution (28), $\dot{U}_1$ est le phaseur de tension, $\dot{I}_1$ est le phaseur de courant $z_1$ est l'impédance de séquence positive du conducteur de distribution (28) en ohms par longueur, et la fonction *imag(y)* définit la prise de la partie imaginaire du terme *y*.

**15.** Appareil (34) pour localiser un défaut dans un système d'électrification ferroviaire (20), le système d'électrification ferroviaire (20) comprenant :
une source d'énergie électrique (26) ; un conducteur de distribution (28) ; un conducteur de retour (30) ; une ligne ferroviaire (22) ; et une pluralité d'autotransformateurs (32), le conducteur de distribution (28) étant configuré pour distribuer de l'énergie électrique de la source d'énergie électrique (26) à un véhicule ferroviaire (24) sur la ligne ferroviaire (22), le conducteur de retour (30) étant configuré pour fournir une voie de retour de courant à la source d'énergie électrique (26), la ligne ferroviaire (22) étant électriquement reliée à la terre, chaque autotransformateur (32) étant agencé le long de la ligne ferroviaire (22) et configuré pour interconnecter électriquement le conducteur de distribution (28), le conducteur de retour (30) et la ligne ferroviaire (22), l'appareil (34) étant configuré pour :

déterminer des phaseurs de tension et de courant à partir d'une tension et d'un courant mesurés au niveau de la source d'énergie électrique (26) ;
déterminer, sur la base des phaseurs de tension et de courant, si le défaut est situé entre les conducteurs de distribution et de retour (28, 30) ou entre le conducteur de distribution (28) et la terre ;
déterminer, sur la base des phaseurs de tension et de courant, l'emplacement du défaut le long du conducteur de distribution (28).

**Figure 1**

**Figure 2**

**Figure 3**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5428549 A

- ES 2507465

**Non-patent literature cited in the description**

- **JESUS SERRANO et al.** A Novel Ground Fault Identification Method for 2 × 5 kV Railway Power Supply Systems. *ENERGIES,* 13 July 2015, vol. 8 (7), 7020-7039